Europäisches Patentamt

**European Patent Office**

**Office européen des brevets**

(19)

(11) Numéro de publication: **0 280 822**
**B1**

(12) **FASCICULE DE BREVET EUROPEEN**

(45) Date de publication du fascicule du brevet:
**22.11.90**

(21) Numéro de dépôt: **87402284.1**

(22) Date de dépôt: **13.10.87**

(51) Int. Cl.⁵: **G01N 1/28**

(54) **Echantillon à perçage muni d'un revêtement et son procédé de préparation.**

(30) Priorité: **05.12.86 FR 8617062**

(43) Date de publication de la demande:
**07.09.88 Bulletin 88/36**

(45) Mention de la délivrance du brevet:
**22.11.90 Bulletin 90/47**

(84) Etats contractants désignés:
**AT BE CH DE ES GB GR IT LI LU NL SE**

(56) Documents cités:
**US-A- 2 494 834**
**US-A- 2 776 596**

**Revue Structure 10, Struers Nouveautés**
**Métallographiques d'avril 1985, fig. 4 (version française)**

(73) Titulaire: **HYPREZ S.A. Société dite :, 4 Terreaux du**
**Temple, CH-1201 Geneve(CH)**

(72) Inventeur: **Broido, Georges Henri Guy, Allée du**
**Chavardon Collonges-sous-Salève,**
**F-74160 Saint-Julien-en-Genevois(FR)**

(74) Mandataire: **Bourgognon, Jean-Marie et al, Cabinet**
**Flechner 22, Avenue de Friedland, F-75008 Paris(FR)**

ACTORUM AG

**Description**

La présente invention se rapporte aux échantillons destinés à être examinés au microscope, notamment à des échantillons de cartes ou plaquettes de circuits imprimés. Ces échantillons comprennent une plaquette ayant un perçage muni d'un revêtement. L'invention vise également des procédés de préparation de ces échantillons.

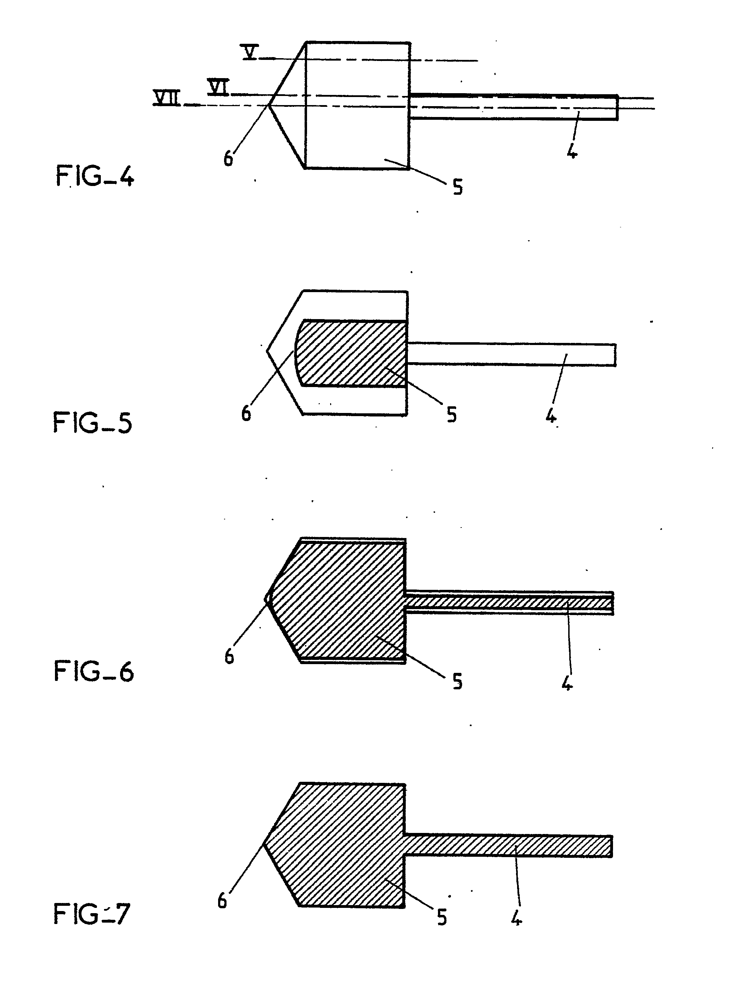

On contrôle les circuits imprimés, et notamment l'épaisseur du revêtement métallique de la paroi de leurs perçages, en examinant au microscope une section passant par le diamètre du perçage à contrôler. Il est essentiel à cet effet que le plan de section passe exactement par l'axe du perçage. En regard de la figure 4 de la revue Structure 10, Struers Nouveautés Métallographiques d'Avril 1985, on démontre mathématiquement la très grande précision requise et on propose d'y parvenir par un procédé de préparation d'échantillons qui consiste à percer à l'avance des trous de référence dans les plaquettes, à y enfiler deux tiges, à suspendre les plaquettes par les tiges au-dessus d'un moule, à emplir le moule d'une résine d'enrobage jusqu'à un niveau inférieur aux tiges, à laisser durcir la résine qui sert à maintenir la plaquette et la poser sous le microscope, à démouler l'échantillon enrobé, à en enlever les tiges et à prépolir, c'est-à-dire à abraser, puis à polir l'échantillon jusqu'aux perçages.

La réussite de ce procédé nécessite une grande précision de l'emplacement et du diamètre des trous de référence dépourvus de toute autre utilité et un moule spécial à flasque formant niveau de référence. Les tiges de mise en position doivent avoir des tolérances très faibles afin que les échantillons soient bien maintenus dans le moule. Elles sont si difficiles à enlever après l'enrobage qu'il a fallu concevoir à cet effet un appareillage spécial dit "extracteur de tiges". Mais, plus encore que de ces difficultés de mise en oeuvre, le procédé souffre d'un défaut grave: l'opérateur n'a aucun moyen de se rendre compte que les opérations se sont passées correctement. Il doit faire une confiance aveugle à la fois à son habileté et aux appareillages. Il peut ainsi rebuter des plaques bonnes, simplement parce que la préparation de l'échantillon n'est pas correcte ou, plus rarement, croire que des plaques sont bonnes alors qu'elles sont défectueuses, mais que le plan de la section n'est pas le bon.

L'invention pallie ces inconvénients par un échantillon préparé par un procédé plus simple, plus rapide et cependant plus sûr que le procédé antérieur. Surtout, l'opérateur peut voir immédiatement à l'oeil nu qu'un échantillon n'a pas été préparé correctement et notamment que la section qui devrait être soumise à l'inspection au microscope n'est pas la bonne.

L'invention a donc pour objet un échantillon destiné à être examiné au microscope et comprenant une plaquette ayant un perçage muni d'un revêtement et enrobée de résine. Suivant l'invention, un gabarit est enrobé aussi dans la résine et la tige du gabarit, de diamètre juste inférieur à celui du perçage, y est enfilée.

En regardant la section, l'opérateur voit immédiatement si la tige est présente sur toute la longueur axiale du perçage. Si ce n'est pas le cas, le plan de la section n'est pas perpendiculaire à l'axe de répétition de l'échantillon. Une erreur a été commise. Il faut préparer un nouvel échantillon.

Suivant un perfectionnement important, le gabarit a une tête cylindrique, de diamètre supérieur à celui de la tige et de même axe longitudinal que celle-ci. Cette fois-ci, l'opérateur voit dans la section non seulement la tige mais aussi la coupe de la tête. Si la cope est trapézoïdale, au lieu d'être rectangulaire, l'échantillon n'a pas été préparé correctement pour la même raison que ci-dessus. Si la largeur, c'est-à-dire la dimension qui est perpendiculaire à l'axe de la tige, de la coupe de la tête est inférieure au diamètre d'origine de la tête, le plan de section est parallèle à ce qu'il devrait être. Il faut préparer un autre échantillon.

Dans le mode de réalisation de l'invention le plus achevé, le gabarit a une tête, dont au moins le tronçon d'extrémité éloigné de la tige est conique. Le contrôle ne nécessite plus une comparaison des dimensions de la cope de la tête, mais simplement de sa forme. Le plan de section n'est pas le bon, si l'angle au sommet du cône n'y apparaît pas.

Le gabarit perdu, enrobé à demeure et abrasé en même temps que l'échantillon, permet ainsi un contrôle des opérations.

Pour compléter ce contrôle, il est recommandé d'enfiler deux gabarits dans deux perçages proches, de préférence de manière que leurs têtes soient d'un même côté de la plaque. Les coupes des deux têtes doivent avoir la même dimension et/ou les deux sommets des cônes doivent apparaître. S'il n'en est pas ainsi, le plan de section n'est pas perpendiculaire à l'axe de répétition. Il faut préparer un autre échantillon.

L'invention a également pour objet un procédé consistant à mettre la plaquette dans un moule ayant un axe de répétition de manière que l'axe de perçage soit horizontal, à emplir le moule d'une résine d'enrobage, à faire durcir la résine pour obtenir un échantillon enrobé et à abraser l'échantillon enrobé jusqu'au plan perpendiculaire à l'axe de répétition passant par un diamètre du perçage, caractérisé en ce qu'il consiste, avant de mettre la plaquette dans le moule, à enfiler à demeure dans le perçage la tige d'un gabarit, constitué de la tige, de diamètre juste inférieur au diamètre du perçage, et d'une tête de même axe que la tige et de diamètre plus grand que celle-ci.

En enfilant deux gabarits en sens inverse dans deux perçages, on est sûr que la plaque est supportée horizontalement sur le fond du moule par les deux têtes des gabarits de même diamètre.

En enfilant deux gabarits dans le même sens, on exclut toute posibilité qu'un plan de section erroné soit considéré comme bon.

Les gabarits sont avantageusement en laiton ou en aluminium teint dans la masse à des colorations différentes suivant les diamètres des tiges. Les gabarits adaptés à des perçages différents sont ainsi plus faciles à reconnaître.

On peut contrôler plusieurs plaquettes à la fois en les enfilant dans les mêmes gabarits.

De préférence, la résine d'enrobage est une résine transparente, notamment une résine méthacrylique.

Au dessin annexé donné uniquement à titre d'exemple :

la figure 1 est une vue en perspective illustrant le premier stade du procédé suivant l'invention,

la figure 2 est une vue de l'échantillon enrobé dans le moule, la paroi antérieure du moule étant enlevée,

la figure 3 est une vue de l'échantillon abrasé jusqu'au plan passant par un diamètre des perçages,

la figure 4 est une vue d'un gabarit sur lequel on indique trois plans de sections correspondant aux figures 5, 6 et 7,

les figures 5, 6 et 7 sont des vues en coupe de l'échantillon abrasé suivant les divers plans indiqués à la figure 4.

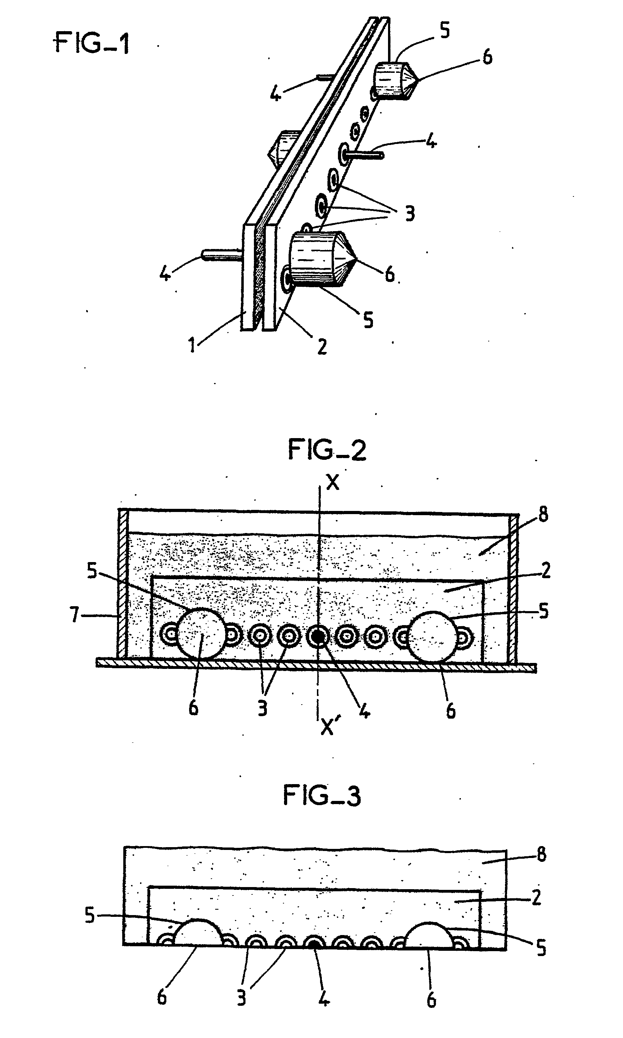

A la figure 1, on contrôle en même temps les plaquettes 1 et 2. Chaque plaquette comporte onze perçages 3 dont la paroi inférieure est revêtue d'un revêtement métallique. Dans trois perçages 3, on enfile des gabarits. Chaque gabarit est constitué d'une tige 4 de diamètre juste inférieur à celui que doit avoir un perçage 3, une fois revêtu d'une épaisseur correcte de revêtement métallique. La tige est prolongée d'une tête comportant une partie cylindrique 5 de diamètre nettement supérieur à celui du perçage et se termine par une partie conique 6. Les gabarits sont identiques. Comme le rayon des parties cylindriques 5 est supérieur à la distance entre le centre des perçages et le bord de la plaquette, les plaquettes 1 et 2 sont maintenues d'une manière parfaitement verticale par les gabarits. Si l'un des gabarits ne peut pénétrer dans un trou, la plaquette doit être rebutée. Si le jeu est trop grand entre la tige 4 et le diamètre d'un perçage 3, au point que la plaquette peut s'incliner par rapport à la verticale, la plaquette doit être rebutée.

Le deuxième stade du procédé consiste à poser l'ensemble réalisé conformément à la figure 1 sur le fond d'un moule 7 horizontal. Le moule a un axe de répétition X, X', notamment un axe de révolution. On emplit le moule d'une résine d'enrobage 8 transparente ou non. On fait durcir la résine pour obtenir un échantillon enrobé. On sort l'échantillon du moule.

Le dernier stade du procédé suivant l'invention consiste à abraser l'échantillon enrobé jusqu'au plan perpendiculaire à l'axe de répétition X, X' passant par un diamètre du perçage. On obtient alors l'échantillon représenté à la figure 3 qui peut être examiné au microscope.

A la figure 5, le plan de la section n'est pas le bon. La tige n'apparaît pas dans le perçage 3. La partie cylindrique 5 a des dimensions bien plus petites que celles qu'elle devrait avoir. Le cône 6 n'a pas de sommet.

A la figure 6, le plan de section n'est pas correct non plus. La partie 5 cylindrique n'a pas les dimensions requises. Surtout, le sommet du cône 6 n'apparaît toujours pas.

A la figure 7, le plan de la section est le bon.

On comprend que si le plan de la section est erroné, tout en passant par l'axe de l'un des gabarits, il ne passera pas par l'axe d'un second gabarit, de sorte que l'un des gabarits montrera que le plan n'est pas le bon, ou la tige sera tronquée, de sorte que là aussi le plan n'est pas le bon.

## Revendications

1. Echantillon destiné à être examiné au microscope et comprenant une plaquette (1) ayant un perçage (3) muni d'un revêtement et enrobée d'une résine (8), caractérisé par un gabarit enrobé aussi dans la résine et dont la tige cylindrique (4), de diamètre juste inférieur à celui du perçage (3), y est enfilée.

2. Echantillon suivant la revendication 1, caractérisé en ce que le gabarit a une tête (5) cylindrique de diamètre supérieur à celui de la tige (4) et de même axe longitudinal que celle-ci.

3. Echantillon suivant la revendication 1 ou 2, caractérisé en ce que le gabarit a une tête, dont au moins le tronçon d'extrémité (6), éloigné de la tige, est conique.

4. Echantillon suivant la revendication 1 ou 3, dans lequel la plaquette comporte au moins deux perçages, caractérisé par deux gabarits enrobés aussi dans la résine et enfilés dans deux perçages de manière que leurs têtes soient de part et d'autre de la plaque.

5. Echantillon suivant l'une des revendications 1 à 4, dans lequel la plaquette comporte au moins deux perçages, caractérisé par deux gabarits enfilés dans deux perçages de manière que leurs têtes soient d'un même côté de la plaquette.

6. Echantillon suivant l'une des revendications 4 ou 5, caractérisé en ce qu'il et tronqué suivant un plan défini par les axes de deux gabarits.

7. Procédé de préparation d'un échantillon suivant l'une des revendications 1 à 6, qui consiste à mettre la plaquette dans un moule ayant un axe de répétition de manière que l'axe de perçage soit horizontal, à emplir le moule d'une résine d'enrobage, à faire durcir la résine pour obtenir un échantillon enrobé et à abraser l'échantillon enrobé jusqu'au plan perpendiculaire à l'axe de répétition passant par un diamètre du perçage, caractérisé en ce qu'il consiste, avant de mettre la plaquette dans le moule, à enfiler à demeure dans le perçage la tige d'un gabarit, constitué de la tige, de diamètre juste inférieur au diamètre du perçage, et d'une tête de même axe que la tige et de diamètre plus grand que celle-ci.

8. Procédé suivant la revendication 6, caractérisé en ce qu'il consiste à enfiler au moins deux gabarits dans le même sens dans au moins deux perçages.

9. Procédé suivant la revendication 6 ou 7, caractérisé en ce qu'il consiste à enfiler au moins deux gabarits en sens inverse dans au moins deux perçages.

## Patentansprüche

1. Probe, die zur Untersuchung mit einem Mikroskop bestimmt ist und eine Platte (1) umfaßt, die eine mit einem Überzug versehene und mit einem Harz (8) umkleidete Bohrung (3) aufweist, gekennzeichnet durch eine ebenfalls von dem Harz umkleidete Bohrlehre, deren zylindrische Stange einen geringfügig kleineren Durchmesser als den der Bohrung (3) aufweist und in diese Bohrung eingesteckt ist.

2. Probe nach Anspruch 1, dadurch gekennzeichnet, daß die Lehre einen zylindrischen Kopf (5) mit einem größeren Durchmesser als dem der Stange (4) und mit der gleichen Längsachse wie diese aufweist.

3. Probe nach Anspruch 1 oder 2, dadurch gekennzeichnet, daß die Lehre einen Kopf aufweist, bei dem wenigstens der äußere, von der Stange abgewandte Endabschnitt (6) konisch ist.

4. Probe nach Anspruch 1 oder 3, bei welcher die Platte wenigstens zwei Bohrungen aufweist, gekennzeichnet durch zwei ebenfalls von dem Harz umkleidete und in die zwei Bohrungen derart eingesteckte Bohrlehren aufweist, daß sich ihre Köpfe auf beiden Seiten der Platte befinden.

5. Probe nach einem der Ansprüche 1 bis 4, bei welcher die Platte wenigstens zwei Bohrungen aufweist, gekennzeichnet durch zwei in die zwei Bohrungen derart eingesteckte Bohrlehren, daß sich ihre Köpfe auf ein- und derselben Seite der Platte befinden.

6. Probe nach einem der Ansprüche 4 oder 5, dadurch gekennzeichnet, daß sie entsprechend einer durch die Achsen der beiden Lehren definierten Ebene abgestumpft ist.

7. Verfahren zur Herstellung einer Probe gemäß einem der Ansprüche 1 bis 6, darin bestehend, daß eine Platte in eine Form gesetzt wird, die eine Repetitionsachse derart aufweist, daß die Achse der Bohrung horizontal verläuft, daß die Form mit einem Umkleidungsharz gefüllt wird, daß man das Harz erhärten läßt, um eine von dem Harz umhüllte Probe zu erhalten, und daß die umkleidete Probe abgeschliffen wird bis zur Ebene, die senkrecht zur Repetitionsachse durch einen Durchmesser der Bohrung verläuft, dadurch gekennzeichnet, daß vor dem Einsetzen der Platte in die Form die Stange einer Bohrlehre zum Verbleib in die Bohrung eingesetzt wird, die besteht aus der Stange mit einem Durchmesser, der geringfügig kleiner ist als der Durchmesser der Bohrung, und einem Kopf mit der gleichen Achse wie die Stange und einem Durchmesser, der größer ist als diese.

8. Verfahren nach Anspruch 6, dadurch gekennzeichnet, daß wenigstens zwei Bohrlehren im gleichen Sinne in wenigstens zwei Bohrungen eingesteckt werden.

9. Verfahren nach Anspruch 6 oder 7, dadurch gekennzeichnet, daß wenigstens zwei Bohrlehren in entgegengesetztem Sinn in wenigstens zwei Bohrungen eingesteckt werden.

## Claims

1. Sample intended to be examined under the microscope comprising a board (1), a coated perforation provided in the board, a resin portion (8), in which the board is embedded, characterised by a checking device which is also embedded in the resin portion and which has a cylindrical rod (4) inserted in the perforation, wherein the diameter of the rod (4) is just less than that of the perforation (3).

2. The sample of claim 1, characterised in that the checking device has a cylindrical head (5) with a diameter greater than that of the rod (4) and the same longitudinal axis as the latter.

3. The sample of claim 1 or 2, characterised in that the checking device has a head, of which at least the end portion (6), remote from the rod, is conical.

4. The sample of claim 1 or 3, wherein the board characterised in that at least two perforations, and two checking devices embedded in the resin portion and inserted into said two perforations in such a way that their heads are on respective sides of the board.

5. The sample of anyone of claims 1–4, in which the board comprises at least two perforations, and two checking devices inserted into the two perforations, so that their heads are on the same side of the board.

6. The sample of claims 4 or 5, in which the checking devices have axes, wherein the sample is truncated along a plane defined by the axes of said two checking devices.

7. Process for preparing the sample of claims 1–6, comprising putting the board in a mould having an axis of symmetry so that the perforation axis be horizontal, filing the mould with a embedding resin, curing the resin to obtain an embedded sample, and abrading the embedded sample as far as a plane perpendicular to the axis of symmetry passing through the diameter of the perforation, characterised in that it comprises before putting the board in the mould, inserting permanently into the perforation the rod of a checking device comprising a rod with a diameter just less than that of the perforation and a head of the same axis of symmetry as the rod and with a diameter greater than the latter.

8. The process of claim 6, caracterised in that it comprises inserting at least two checking devices in the same direction into at least two perforations.

9. The process of claim 6 or 7, caracterised in that it comprises inserting at least two checking devices in opposite directions into at least two perforations.

EP 0 280 822 B1

FIG_1

FIG_2

FIG_3

FIG_4

FIG_5

FIG_6

FIG_7